(19) Europäisches Patentamt
European Patent Office
Office européen des brevets

(11)  EP 1 967 859 B1

(12)  EUROPÄISCHE PATENTSCHRIFT

(45)  Veröffentlichungstag und Bekanntmachung des Hinweises auf die Patenterteilung:
      01.09.2010  Patentblatt 2010/35

(51)  Int Cl.:
      *G01R 31/00* (2006.01)     *G06F 1/12* (2006.01)

(21)  Anmeldenummer: 08151797.1

(22)  Anmeldetag: 22.02.2008

(54)  **Verfahren und Vorrichtung zur Verarbeitung von Daten oder Signalen mit unterschiedlichen Synchronisationsquellen**

Method and device for transmitting data or signals with various synchronisation sources

Procédé et dispositif de traitement de données ou de signaux à l'aide de sources de synchronisation différentes

(84)  Benannte Vertragsstaaten:
      **AT DE FR GB IT SE**

(30)  Priorität: **06.03.2007  AT 1362007 U**

(43)  Veröffentlichungstag der Anmeldung:
      **10.09.2008  Patentblatt 2008/37**

(73)  Patentinhaber: **AVL List GmbH**
      **8020 Graz (AT)**

(72)  Erfinder:
      • **Peinsipp, Dietmar**
        **8020, Graz (AT)**

      • **Priller, Peter**
        **8111, Judendorf-Strassengel (AT)**

(74)  Vertreter: **Weiss, Christian**
      **Pinter, Laminger & Weiss OG**
      **Patentanwälte**
      **Prinz-Eugen-Strasse 70**
      **1040 Wien (AT)**

(56)  Entgegenhaltungen:
      **US-A- 5 717 704     US-A- 5 896 524**

**Beschreibung**

Die gegenständliche Erfindung betrifft ein Verfahren und eine Vorrichtung zur Verarbeitung von Daten oder Signalen mit unterschiedlichen Synchronisationsquellen in einer Verarbeitungseinrichtung.

In einer Verarbeitungseinrichtung, insbesondere in einem Mess-, Prüf- oder Steuergerät für den Antriebstrang oder Komponenten davon, wie z.B. ein Automatisierungssystem, eine Steuerungseinrichtung oder eine Messdatenauswerte- oder -aufzeichnungseinheit, ist es oftmals erforderlich Messdaten aus unterschiedlichen Quellen miteinander zu verknüpfen. Messdaten aus unterschiedlichen Quellen können dabei zu unterschiedlichen Taktquellen synchronisiert sein, z.B. durch eine Abtastung und Digitalisierung. Um unterschiedlich synchronisierte Messdaten nun in einer übergeordneten Verarbeitungseinrichtung untereinander oder miteinander verknüpfen zu können, ist es erforderlich, den zeitlichen Bezug der Messdaten beizubehalten oder die jeweiligen Messdaten zeitlich miteinander in Bezug zu setzen. Das kann also z.B. bedeuten, ein Messdatum einer Quelle mit einer ersten Taktquelle mit dem zeitlich zugehörigen Messdatum einer Quelle mit einer zweiten Taktquelle miteinander zu verknüpfen. Stimmt der zeitliche Bezug der beiden Messdaten nicht, so wird die Verknüpfung dieser beiden Messdaten ein falsches Ergebnis liefern, da Messdaten verknüpft werden, die nicht zum gleichen Zeitpunkt (von einer globalen Absolutzeit betrachtet) entstanden sind. Weiters muss der zeitliche Bezug von Messdaten einer Quelle mit einer Taktquelle auch in der übergeordneten Verarbeitungseinrichtung beibehalten werden, um zu gewährleisten, dass diese untereinander zeitlich korrekt verknüpft werden können. Bisher wurden solche Messdaten so miteinander in Bezug gesetzt, dass die Messdaten einer Quelle zur anderen Quelle synchronisiert worden sind, wobei aber der Bezug zur ursprünglichen Synchronisationsquelle verloren ging. Eine andere bekannte Möglichkeit ist, die Quelle selbst zu synchronisieren, z.B. ein Bussystem auf das andere zu synchronisieren, was aber nicht immer möglich ist.

Aus der US 5 896 524 A ist ein Verfahren bekannt, bei des es es darum geht, Events, die zu bestimmten lokalen Zeiten stattfinden, in eine globale Zeit überzuführen, um den zeitlichen Ablauf der Events in einem Postprozessor nachvollziehbar zu machen. Die Events unterschiedlicher Zeitbasis werden daher im Postprozessor zu einer globalen Zeitbasis zusammengeführt. Damit ist im Postprozessor für alle Synchronisationsquellen nur mehr eine Zeitebene vorhanden, die jedoch als Quelltakt eine neu erzeugte globale Zeitbasis verwendet. Die Events werden nur mehr in dieser neuen globalen Zeitbasis behandelt und nicht synchron mit dem Quelltakt der einzelnen Synchronisationsquellen. Dieses Verfahren ist daher ungeeignet, um Signale und Daten aus unterschiedlichen Systemen unter Aufrechterhaltung der Synchronität zu einem jeweiligen Quelltakt miteinander zu verknüpfen.

Um z.B. die dynamischen Vorgänge verstehen zu können, die für die emissionsoptimierte Auslegung von motorischen Funktionen, z.B. auf einem Motorprüfstand, notwendig sind, ist es z.B. erforderlich, Messdaten aus unterschiedlichen, getrennten Geräten, ausgestattet mit unterschiedlichen Datenerfassungseinrichtungen und Bussystemen, zusammenzufassen, zu synchronisieren und mit genauer zeitlicher Zuordnung auszuwerten. Das gelingt zurzeit nur unvollkommen und macht insbesondere bei der Emissionsoptimierung dynamischer Vorgänge erhebliche Schwierigkeiten. Eine besondere Bedeutung kommt dabei den Daten aus Motorsteuerungen (ECU) zu, die mit anderen hochgenau erfassten Prüfstandsdaten zeitlich in Einklang gebracht werden müssen. Die Problematik liegt dabei in den bei ECU Systemen durch die eingesetzten Bussysteme auftretenden Zeitverzögerungen, die nicht reduziert werden können.

Auch sind aktuelle Automatisierungssysteme den zukünftigen Anforderungen moderner Prüfstände in Bezug auf die Vereinheitlichung mehrerer Zeit-Server (z.B. Active-Directory Time Server, mehrere Prüfstandsysteme als Time-Master, oder Datenbusse mit zueinander asynchronen Taktquellen) nur bedingt gewachsen.

Beispiel: Ein synchrones System, genannt System A, umfasst unter Anderem mehrere elektronische Control-Units (ECU) an einem Flexray-Netzwerk. System A könnte z.B. zur Steuerung eines Powerpacks (Motor + Getriebe) dienen. Knoten (also z.B. Komponenten, die in diesem Netzwerk hängen) in diesem System sind zueinander streng synchronisiert und die Taktquelle ist meist eine bestimmte ECU. Ein Synchronisieren dieses Systems auf einen anderen Takt, z.B. eine externe Taktquelle, ist unerwünscht oder gar unmöglich. Ein zweites System, genannt System B, wäre beispielsweise ein Echtzeit-Ethernet-Netzwerk mit Mess- und Regeltechnik am Prüfstand. Dieses System B ist wiederum in sich streng synchronisiert, aber mit keinerlei zeitlichem Zusammenhang zum Flexray-Netzwerk von System A. Eine Quer-Synchronisation der Takte zwischen diesen Systemen ist daher nicht möglich. Trotzdem müssen unter Umständen Daten oder Signale aus den verschiedenen, zueinander nicht synchronen Systemen miteinander zeitlich korrekt (also z.B. bezogen auf eine absolute Zeit) verknüpft werden. Dabei muss aber das ursprüngliche Signal oder Datum im zugehörigen System natürlich auch mit der ursprünglichen Synchronisation bestehen bleiben, da es auch in diesem System benötigt werden kann.

Es ist daher eine Aufgabe, ein Verfahren und eine Vorrichtung zur Verarbeitung von Signalen mit unterschiedlichen Synchronisationsquellen in einer Verarbeitungseinrichtung anzugeben, mit dem problemlos Daten oder Signale unterschiedlicher Synchronisationsquellen verarbeitet werden können, ohne den ursprünglichen zeitlichen Bezug zu verlieren.

Diese Aufgabe wird für das Verfahren und die Vorrichtung erfindungsgemäß dadurch gelöst, dass in der Verarbeitungseinrichtung für jede Synchronisationsquelle eine Zeitebene eingeführt wird, wobei in jeder Zeitebene als Quelltakt der Takt der Synchronisationsquelle verwendet wird und die dieser Synchronisationsquelle zugeordneten Daten oder Signale in der zugehörigen Zeitebene synchron mit dem Quelltakt der Synchronisationsquelle behandelt werden, also eingelesen und/oder verarbeitet und/oder ausgegeben werden. Im Gegensatz zu herkömmlichen Methoden wird hier nun nicht versucht, verschiedene unabhängige Systeme zueinander oder auf eine bestimmte Taktquelle zu synchronisieren. Dies wäre aufgrund der Eigenständigkeit dieser Systeme auch nicht gewünscht und nicht möglich. Die zeitlichen Bezüge der Daten und Signale bleiben in der zugehörigen Zeitebene vielmehr erhalten und können innerhalb der Zeitebene ebenfalls unter Beibehaltung des zeitlichen Bezugs auch einfach miteinander verknüpft werden. Es ist mit diesem Verfahren auch möglich, Signale mit unterschiedlich starkem zeitlichen Jitter, oder sogar Echtzeit- und Nicht-Echtzeit-Signale in einer Verarbeitungseinrichtung zu integrieren, ohne den zeitlichen Ursprungsbezug zu verlieren. Dieses Verfahren ist dabei auch unabhängig von der jeweiligen Taktrate des betrachteten Systems und kann damit (auch gleichzeitig) sowohl azyklisch als auch zyklisch synchrone Systeme verarbeiten. Man könnte das Konzept daher auf eine beliebige Anzahl in sich synchroner, aber zu den anderen Systemen asynchroner Systeme erweitern.

Neben zyklischer Synchronität (d.h. gleichbleibende Taktzeiten der Taktquelle) ist es beim erfindungsgemäßen Verfahren auch denkbar, zeitlich gesehen azyklische, aber trotzdem in sich synchronisierte Systeme zu verwenden. In diesem Fall wäre die Zykluszeit variabel, sie wäre aber wiederum für alle Knoten innerhalb eines Systems gleich. Ein Anwendungsbeispiel wäre eine Messdatenerfassung basierend auf einer vom Kurbelwinkel eines Verbrennungsmotors abhängigen Synchronisation, bei der abhängig von der Drehzahl also unterschiedliche Taktzeiten auftreten.

Zwei Signale unterschiedlicher Zeitebenen können erfindungsgemäß aber auch miteinander verknüpft werden, indem ein Signal in die Zeitebene des anderen Signals importiert wird und damit der zeitliche Bezug zur Zeitebene, in die importiert wird, hergestellt wird. Die beiden Signale, die nach dem Importieren dieselbe Zeitbasis haben, können einfach und zeitlich korrekt verknüpft werden. Das Importieren kann vorteilhaft entweder durchgeführt werden, indem das zu importierende Signal im Quelltakt der Zeitebene, in die es importiert werden soll, abgetastet wird oder indem das zu importierende Signal auf den Quelltakt der Zeitebene, in die es importiert werden soll, interpoliert wird.

Bevorzugt wird in einer Zeitebene eine lokale Absolutzeit gebildet, um zeitabhängige Funktionen, wie z.B. eine Integration, durchführen zu können. Eine lokale Absolutzeit lässt sich einfach gemäß der Beziehung $TZ = t_0 + TCM * CMT$ bilden, wobei $TZ$ die lokale Absolutzeit, $t_0$ eine Startzeit, $T_{CM}$ eine Zeitkonstante und $CMT$ die Anzahl der seit dem Startzeitpunkt vergangen Takte angibt.

Daten oder Signale einer ersten Zeitebene können besonders einfach und vorteilhaft in eine zweite Zeitebene importiert werden, indem die lokale Absolutzeit der ersten Zeitebene in die lokale Absolutzeit der zweiten Zeitebene konvertiert wird.

Die lokale Absolutzeit der ersten Zeitebene wird bevorzugt in die lokale Absolutzeit der zweiten Zeitebene konvertiert, indem die Zeitkonstante der ersten Zeitebene an die lokale Absolutzeit der zweiten Zeitebene angepasst wird. Damit erreicht man eine laufende Anpassung und es ergibt sich daraus eine adaptive Umrechnung der lokalen ersten Absolutzeit in eine zweite Absolutzeit. Diese Umrechnung ist damit auch in der Lage, mit Unstetigkeiten, wie z.B. Zeitsprünge, in der Absolutzeit fertig zu werden, da in einem solchen Fall die Umrechnung durch die Anpassung einfach nachgezogen wird. Besonders einfach und vorteilhaft erfolgt die Anpassung gemäß der Beziehung $T_{CM} = (TZ_{TL2} - t_0)/CMT$.

Eine besonders einfache Konvertierung erhält man bereits, indem die Startzeit der Absolutzeit zu Beginn auf die aktuelle lokale Absolutzeit der Zeitebene, in die importiert wird, gesetzt wird. Diese Konvertierung funktioniert zwischen Zeitebenen mit gleichen Zeitkonstanten besonders gut. Für Zeitebenen mit ungleichen Zeitkonstanten funktioniert diese Umrechnung zumindest für kurze Zeiträume. Ansonsten kann in diesem Fall auch die Anpassung der Zeitkonstanten zusätzlich durchgeführt werden.

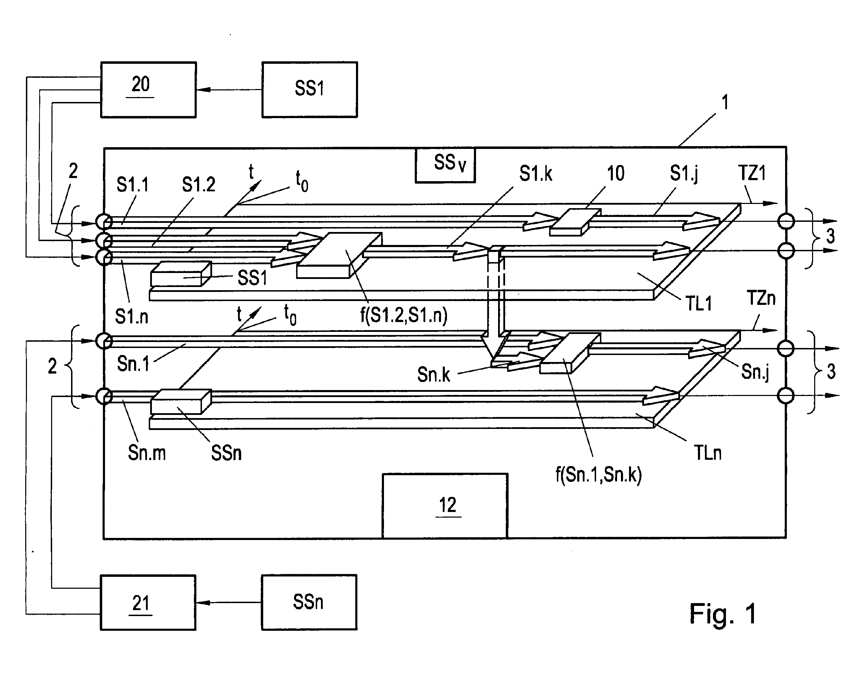

Die gegenständliche Erfindung wird im nachfolgenden anhand der schematischen und ein vorteilhaftes Ausführungsbeispiel zeigenden Figur 1 beschrieben.

Fig. 1 zeigt eine Verarbeitungseinrichtung 1, die über bestimmte Eingabeschnittstellen 2 eine Reihe von Signalen oder Daten von unterschiedlichen Signal- oder Datenquellen 20, 21 empfängt, z.B. von einer ersten Signal- oder Datenquelle 20, z.B. ein Netzwerk mit einer Reihe von Steuereinrichtungen, die Signale oder Daten S1.1, S1.2 bis S1.m senden, und von einer zweiten Signal- oder Datenquelle 21, z.B. ein Netzwerk mit Mess- und Regeltechnik, die Signale oder Daten Sn.1 bis Sn.m senden, z.B. Messdaten. Jede Signal- oder Datenquelle 20, 21 hat dabei eine eigene interne (wie z.B. ein Taktgeber) oder externe (wie z.B. der Takt eines Datenbus) Synchronisationsquelle SS1, SSn, wie z.B. eine Taktquelle, auf die sämtliche Signale oder Daten, die von dieser Signal- oder Datenquelle 20, 21 erzeugt werden, synchronisiert sind. Diese Synchronisationsquellen SS1, SSn stehen dabei in der Regel in keinem zeitlichen Bezug zueinander. Für die Anwendung der Erfindung können natürlich beliebig viele solcher Signal- oder Datenquellen 20, 21 mit zugehöriger Synchronisationsquelle SS1, SSn vorhanden sein. Auch ist es denkbar, dass mehrere Signal- oder Datenquelle 20, 21 dieselbe Synchronisationsquelle haben, womit die Signale oder Daten dieser Signal- oder Datenquellen 20, 21 in der Verarbeitungseinrichtung 1 bzgl. der zeitlichen Synchronisation gleich behandelt werden können.

Die Verarbeitungseinrichtung kann z.B. ein Steuergerät für den Motor (ECU), das Getriebe, den Antriebsstrang oder das gesamte Fahrzeug sein, oder auch ein Prüfstandsmessgerät oder ein Prüfstandsautomatisierungssystem oder-regelungssystem, das Daten oder Signale von unterschiedlichen Quellen mit unterschiedlicher Synchronität erhält.

Um die Signale bzw. Daten der unterschiedlichen Signal- oder Datenquellen 20, 21 in der Verarbeitungseinrichtung 1 unter Beibehaltung der jeweiligen zeitlichen Synchronisation zur eigenen Synchronisationsquelle SS1, SSn verarbeiten zu können, wird in der Verarbeitungseinrichtung 1 für jede Synchronisationsquelle SS1 ... SSn eine eigene Zeitebene TL1, TLn in der Verarbeitungseinrichtung 1 eingeführt. Alle Daten bzw. Signale S1, Sn einer bestimmten Synchronisationsquelle SS1, SSn werden in der zugehörigen Zeitebene TL1, TLn synchron mit dem "Quell-Takt" der Synchronisationsquelle SS1, SSn der dazugehörigen Signal- oder Datenquelle 20, 21 eingelesen, verarbeitet und/oder ausgegeben. Dazu erfolgt der Signal- oder Datenfluss zwischen der Signal- oder Datenquelle 20, 21 und der Verarbeitungseinrichtung 1 vorteilhaft zeitlich synchron mit der jeweiligen Signal- oder Datenquelle 20, 21, um hier keinen Zeitfehler zu generieren.

Selbstverständlich kann auch eine Zeitebene mit der Synchronisationsquelle SSv der Verarbeitungseinrichtung 1 gebildet werden. Damit können z.B. Daten und Signale S1, Sn auch bezogen auf die Synchronisationsquelle SSv der Verarbeitungseinrichtung 1 behandelt werden, also eingelesen, aufgezeichnet, verarbeitet oder ausgegeben werden.

Die unterschiedlichen Zeitebenen TL1, TLn existieren in der Verarbeitungseinrichtung 1 zueinander parallel und idealerweise ohne Abhängigkeiten. In der Praxis können jedoch Querabhängigkeiten entstehen, z.B. wenn die Hardware (HW) und Software (SW) in der Verarbeitungseinrichtung 1 nicht beliebig parallelisierbar ist. Z.B. durch entsprechende Priorisierung der bearbeitenden Threads in der SW, sowie durch performante Implementierung oder durch multipler Verarbeitungseinrichtungen (Multiprozessor-/Multicore-Systeme) kann diese Querabhängigkeit jedoch klein und innerhalb erlaubter Toleranzen gehalten werden. Eine Querabhängigkeit fällt dann als zeitlicher (vernachlässigbarer) Jitter in der jeweiligen Zeitebene auf.

Daten und Signale S1, Sn bleiben in der Verarbeitungseinrichtung 1 stets auf der Zeitebene TL1, TLn ihrer zugehörigen Synchronisationsquelle SS1, SSn und damit stets synchron mit ihrem Herkunftssystem. Der zeitliche Bezug der Daten und Signale S1, Sn bleibt daher immer erhalten. Die Verarbeitungen in der Verarbeitungseinrichtung 1, z.B. Filterung, oder Verknüpfung innerhalb der Zeitebene, erfolgt in der Verarbeitungseinrichtung 1 wiederum synchron in der jeweiligen Zeitebene TL1, TLn. Damit können die Ergebnissignale oderdaten auch wieder synchron zur zugehörigen Synchronisationsquelle SS1, SSn zurück ausgegeben werden. Z.B. werden in Fig. 1 die Signal S1.2 und S1.n gemäß einer bestimmten Funktion f(S1.2, S1.n) miteinander zu einem neuen Signal S1.k verknüpft. Die Funktion f(S1.2, S1.n) kann dabei eine beliebige mathematische Funktion oder Berechnung sein, die zur Erzeugung des neuen Signals S1.k benötigt wird. Die Daten S1.1 werden z.B. in einem Filter 10 gefiltert (z.B. ein Tiefpass) und werden als neues Signal S1.j ausgegeben. Die neuen Signale S1.k und S1.j sind damit ebenfalls wieder zeitlich synchron zur zugehörigen Synchronisationsquelle SS1 der Zeitebene TL1. Zusätzliche Latenzzeit wird damit völlig vermieden, was einen wesentlichen Vorteil in der Regelungstechnik darstellt. Auch wird ein Phasenfehler durch unterschiedliche Zeitpunkte von Signalabtastung durch die vollständig synchrone Verarbeitung ausgeschlossen.

Die gewünschten Manipulationen an den Daten und Signalen S1, Sn kann dabei vorteilhaft in einer Berechnungseinheit 12 der Verarbeitungseinrichtung 1, z.B. ein Mikroprozessor oder eine DSP (Digital Signal Processing) -Einheit erfolgen.

Die Ausgabe von verarbeiteten Signalen oder Daten S1, Sn kann dabei über eine entsprechende Ausgabeschnittstelle 3 der Verarbeitungseinrichtung 1 erfolgen.

Bei einer Verknüpfung von Daten oder Signalen S1, Sn unterschiedlicher Signal- oder Datenquellen 20, 21, also unterschiedlicher Zeitebenen TL1, TLn, innerhalb der Verarbeitungseinrichtung 1 wird erfindungsgemäß die unterschiedliche Synchronität (Phasenlage, Zykluszeit) der Daten und Signale S1, Sn beachtet und erhalten. Eine solche Verknüpfung erfolgt dabei wieder vorteilhaft in der Berechnungseinheit 12.

Beispiel:

Eine Verarbeitung in der Verarbeitungseinrichtung 1 wäre z.B. eine Verknüpfung bzw. Verrechnung der allgemeinen Form y = f (a, b). Dabei kommt Datum bzw. Signal "a" von einer ersten Signal- oder Datenquelle A (ist also synchron zu A), und "b" von einer zweiten Signal- oder Datenquellen B (und damit synchron zu B). Datum oder Signal "y" kann nun sowohl zu System A zurückgespielt werden (und damit zu A synchronisiert) als auch zu B, aber auch zu einer dritten Signal- oder Datenquelle C. Die Anzahl der Signal- oder Datenquellen 20, 21 und der Daten und Signale ist dabei nicht beschränkt.

Die Verknüpfung von Daten oder Signalen S1, Sn unterschiedlicher Zeitebenen TL1, TLn geschieht, in dem ein Signal von einer in die andere Zeitebene importiert wird, aber in der ursprünglichen Zeitebene gleichzeitig weiter existiert. Dieser Import kann nach verschiedenen Kriterien erfolgen, z.B. durch Abtastung des Ausgangs Signals oder Datums im Takt der Zielzeitebene, oder aufwändiger durch z.B. Interpolation vom Quelltakt auf einen Zieltakt und damit Vorausschätzung des neuen Wertes. Bei einer solchen Interpolation wird z.B. zum Taktzeitpunkt der Zielebene der zeitlich letzte (jüngste) Wert der Quellebene sowie eine Anzahl k vorherliegender Werte hergenommen, und daraus über die Zeitdifferenz, die zwischen dem letzten Abtastschritt der Quellebene und der Erfassungszeit durch die Zielebene liegt, interpoliert.

Der Import kann in einer Importeinheit erfolgen, die entweder in der Berechnungseinheit 12 implementiert ist, z.B. als Mikroprozessor oder DSP oder auch in Hardware, oder die Berechnungseinheit 12 selbst ist.

Die Entscheidung, welches Signal wohin importiert wird, kann von der Verarbeitungseinrichtung 1 automatisch getroffen werden. Maßgeblich kann dabei sein, in welcher Zeitebene die Ausgabe des Ergebnisses erfolgt. In dieser Zeitebene kann dann auch die Verknüpfung erfolgen - die Verknüpfung wird also von der dieser Zeitebene zugeordneten Synchronisationsquelle getriggert.

In Fig. 1 wird z.B. das Signal S1.k durch die Importeinheit von einer ersten Zeitebene TL1 in ein Signal Sn.k einer anderen Zeitebene TLn importiert, wie in Fig. 1 durch den Pfeil von Zeitebene TL1 zur Zeitebene TLn angedeutet. Ab dem Import existiert das zu importierende Signal S1.k und das importierte Signal Sn.k parallel in beiden Zeitebenen TL1, TLn, jeweils zeitlich auf die Synchronisationsquelle SS1, SSn bezogen. In der Zeitebene TLn kann das importierte Signal Sn.k z.B. wieder gemäß einer Funktion f(Sn.1, Sn.k) zu einem neuen Signal Sn.j verknüpft, das wiederum zur Synchronisationsquelle SSn der zugehörigen Zeitebene TLn synchronisiert ist.

Es kann aber natürlich auch sein, dass eine Ausgabe in mehreren Zeitebenen notwendig ist. In diesem Fall gibt es in jeder dieser Zeitebenen eine Verknüpfung, die jeweils in der Zeitebene getriggert ist. Die Signale oder Daten werden dabei jeweils in die andere Zeitebene importiert.

Beispiel:

y = f(a,b) muss in A und B ausgegeben werden. In der Zeitbene für A wird also 'a' direkt, 'b' importiert herangezogen und mit einer Rechenfunktion f(a,b) verknüpft. In der Zeitebene für B wird 'b' direkt, 'a' importiert herangezogen und in einem weiteren Rechenfunktion f(a,b) ebenfalls verknüpft, nun allerdings synchron zu B.

Ein Import von Daten oder Signalen S1, Sn von einer Zeitebene in eine andere Zeitebene kann z.B. auch zur Signaldarstellung, -diagnose oder -logging von Signalen auf oder zwischen den Zeitebenen erforderlich sein,

Das Aufzeichnen oder die Anzeige von Werten in der Verarbeitungseinrichtung 1 kann dabei jeweils synchron zur zugehörigen Zeitebene, oder aber auch "absolut", also bezogen auf einen absoluten Takt, z.B. einer Synchronisationsquelle SSv der Verarbeitungseinrichtung 1, erfolgen.

Jede der Zeitebenen TL1, TLn der Verarbeitungseinrichtung 1 kann in sich auch lokale Absolutzeiten TZ1, TZn bilden, wie in Fig. 1 durch die Zeitstrahlen angedeutet. Das heißt, dass jede Zeitebene TL1, TLn sozusagen eine lokale Uhr hat. Die lokale Absolutzeit TZ1, TZn kann dabei z.B. gemäß der Beziehung

$$TZ = t_0 + T_{CM} * CMT$$

gebildet werden. Wobei $t_0$ eine Startzeit zu Beginn der Taktung der Zeitebene durch Synchronisationsquelle, CMT die Anzahl der Takte seit Beginn der Taktung und $T_{CM}$ eine Zeitkonstante der Taktung der Synchronisationsquelle ist. Eine solche Berechnung ist z.B. für zeitlich zyklische Systeme sinnvoll. Die lokale Absolutzeit TZ kann aber auch natürlich beliebig anders berechnet werden.

Jede dieser lokalen Absolutzeiten TZ1, TZn kann aber jederzeit auch in eine andere lokale Absolutzeit konvertiert werden, z.B. durch eine geeignete Projektion. Durch eine solche Konvertierung kann natürlich ebenfalls ein Signal oder Datum S1, Sn einer Zeitebene TL1, TLn in eine andere Zeitebene importiert werden.

Die Konvertierung der lokalen Absolutzeiten TZ1, TZn ist z.B. bei einer Verbindung eines Echtzeitsystems, wie z.B. die Datenerfassung eines Prüfstandes in einem Automatisierungssystem (=Signal- oder Datenquelle), mit einem Nicht-Echtzeitsystem, wie z.B. ein Betriebssystem (wie z.B. Windows) unter dem die Automatisierungs-SW läuft (=Verarbeitungseinrichtung), erforderlich. Der Echtzeittakt darf dabei natürlich nicht beeinflusst werden, um eine korrekte Datenerfassung zu gewährleisten. Andererseits lässt das Betriebssystem unter Umständen nicht zu, dass die Systemzeit, z.B. ein PC interner Taktgeber oder eine externe Netzwerk-Zeit, z.B. von einem Windows Active Directory Service, geändert wird. Trotzdem sind die Signale bzw. Daten dieser beiden Systeme zeitlich miteinander zu verknüpfen.

Die lokale Absolutzeit $TZ_{RT}$ im Echtzeitsystem wird wieder gemäß der obigen Beziehung gebildet, $TZ_{RT}$ = $t_0 + T_{CM}*CMT$. Dabei ist $t_0$ wieder eine Startzeit zu Beginn der Taktung der zugehörigen Zeitebene durch die zugehörige Synchronisationsquelle, CMT die Anzahl der Takte seit Beginn der Taktung (z.B. ein Zählerstand eines Zählers) und $T_{CM}$ die Zeitkonstante der Taktung des Echtzeitsystems, mit der CMT inkrementiert wird.

Zur Konvertierung dieser Echtzeit $TZ_{RT}$ in eine Nicht-Echtzeit $TZ_{NRT}$ der Nicht-Echtzeit-Zeitebene, wird $t_0$ zu Beginn auf den aktuellen Wert der Nicht-Echtzeit $TZ_{NRT}$ gesetzt, also $t_0 = TZ_{NRT}$. Die Zeitreferenz für das ganze System (Verarbeitungseinrichtung) ist nun die Nicht-Echtzeit $TZ_{NRT}$. Um die unterschiedlichen Synchronisationsquellen der Echtzeit-Zeitebene und der Nicht-Echtzeit-Zeitebene zu berücksichtigen, die auch auseinander laufen können, ist nun auch noch die Zeitkonstante $T_{CMRT}$ der Echtzeit-Zeitebene an die lokale Absolutzeit der Nicht-Echtzeit-Zeitebene $TZ_{NRT}$ anzupassen. Diese Anpassung erfolgt z.B. gemäß der Beziehung $T_{CMRT} = (TZ_{NRT} - t_0) / CMT$. Damit kann nun laufend ein Zeitpunkt der Echtzeit-Zeitebene in einen entsprechenden Zeitpunkt der Nicht-Echtzeit-Zeitebene umgerechnet werden, wobei die Ausgangsdaten in der Verarbeitungseinrichtung natürlich weiterhin auch in der Echtzeit-Zeitebene, also synchron mit der Synchronisationsquelle der Echtzeit-Zeitquelle, bestehen bleiben.

Die Anpassung der Zeitkonstante $T_{CM}$ erfolgt dabei laufend und es ergibt sich daraus eine adaptive Umrechnung der lokalen Echtzeit $TZ_{RT}$ in eine Nicht-Echtzeit $TZ_{NRT}$. Diese Umrechnung ist damit auch in der Lage, mit Unstetigkeiten, wie z.B. Zeitsprünge (z.B. durch die Umstellung von Sommer- auf Winterzeit), der Nicht-Echtzeit $TZ_{NRT}$ fertig zu werden, da in einem solchen Fall die Umrechnung durch die Anpassung einfach nachgezogen wird. Die durch die Umrechnung resultierende Zeit steigt dabei trotzdem streng monoton.

Die oben beschriebene Konvertierung funktioniert natürlich zwischen jeden beliebigen Zeitebenen, also nicht nur zwischen einer Echtzeit-Zeitebene und einer Nicht-Echtzeit-Zeitebene, analog. Dazu muss in den obigen Beziehungen lediglich zur Verallgemeinerung $TZ_{RT}$ mit dem allgemeinen TZ1 und $TZ_{NR}$ mit dem allgemeinen TZn, wobei TZ1 und TZn für die Absolutzeit einer beliebigen ersten und zweiten Zeitebene TL1 und TLn steht, ausgetauscht werden.

Die obigen Ausführungen zum Konvertieren und Importieren wurden immer nur bezüglich zwei Zeitebenen gemacht. Selbstverständlich kann das erfindungsgemäße Verfahren aber auf eine beliebige Anzahl von Zeitebenen erweitert werden. In jede Zeitebene kann eine beliebige Anzahl von Signalen oder Daten beliebiger anderer Zeitebenen importiert und verarbeitet werden.

**Patentansprüche**

1. Verfahren zur Verarbeitung von Daten oder Signalen mit unterschiedlichen Synchronisationsquellen in einer Verarbeitungseinrichtung (1), insbesonders in einem Mess-, Prüf- oder Steuergerät für den Antriebstrang oder Komponenten davon, **dadurch gekennzeichnet, dass** in der Verarbeitungseinrichtung (1) für jede Synchronisationsquelle (SS1, SSn) eine Zeitebene (TL1, TLn) eingeführt wird, wobei in jeder Zeitebene (TL1, TL2) als Quelltakt der Takt der Synchronisationsquelle (SS1, SSn) verwendet wird und die dieser Synchronisationsquelle (SS1, SSn) zugeordneten Daten oder Signale (S1, Sn) in der zugehörigen Zeitebene (TL1, TL2) synchron mit dem Quelltakt der Synchronisationsquelle (SS1, SSn) behandelt werden.

2. Verfahren nach Anspruch 1, **dadurch gekennzeichnet, dass** zwei Signale oder Daten (S1, Sn) unterschiedlicher Zeitebenen (TL1, TLn) miteinander verknüpft werden, indem das Signal oder Datum (S1, Sn) einer ersten Zeitebene (TL1) in eine zweite Zeitebene (TLn) importiert wird und die Signale oder Daten in dieser zweiten Zeitebene (TL1, TLn) verknüpft werden.

3. Verfahren nach Anspruch 2, **dadurch gekennzeichnet, dass** das zu importierende Signal oder Datum (S1, Sn) im Quelltakt der Zeitebene (TLn), in die es importiert werden soll, abgetastet wird.

4. Verfahren nach Anspruch 2, **dadurch gekennzeichnet, dass** das zu importierende Signal oder Datum (S1, Sn) auf den Quelltakt der Zeitebene (TLn), in die es importiert werden soll, interpoliert wird.

5. Verfahren nach einem der Ansprüche 1 bis 4, **dadurch gekennzeichnet, dass** in einer Zeitebene (TL1, TLn) eine lokale Absolutzeit (TZ1, TZn) gebildet wird.

6. Verfahren nach Anspruch 5, **dadurch gekennzeichnet, dass** eine lokale Absolutzeit (TZ1, TZn) gemäß der Beziehung $TZ = t_0 + T_{CM} * CMT$ gebildet wird, wobei TZ die lokale Absolutzeit, $t_0$ eine Startzeit, $T_{CM}$ eine Zeitkonstante der Taktung und CMT die Anzahl der seit dem Startzeitpunkt vergangen Takte angibt.

7. Verfahren nach Anspruch 5 oder 6, **dadurch gekennzeichnet, dass** Daten oder Signale (S1, Sn) einer ersten Zeitebene (TL1) in eine zweite Zeitebene (TLn) importiert werden, indem die lokale Absolutzeit (TZ1) der ersten Zeitebene (TL1) in die lokale Absolutzeit (TZn) der zweiten Zeitebene (TZn) konvertiert wird.

8. Verfahren nach Anspruch 7, **dadurch gekennzeichnet, dass** die lokale Absolutzeit (TZ1) der ersten Zeitebene (TL1) in die lokale Absolutzeit (TZ2) der zweite Zeitebene (TL2) konvertiert wird, indem die Zeitkonstante ($T_{CM}$) der ersten Zeitebene (TL1) an die lokale Absolutzeit (TZ2) der zweiten Zeitebene (TL2) angepasst wird.

9. Verfahren nach Anspruch 8, **dadurch gekennzeichnet, dass** die Anpassung gemäß der Beziehung $T_{CM} = (TZ2 - t_0)/CMT$ durchgeführt wird.

10. Verfahren nach einem der Ansprüche 7 bis 9, **dadurch gekennzeichnet, dass** die Startzeit ($t_0$) zu Beginn auf die aktuelle lokale Absolutzeit (TZ2) der zweiten Zeitebene (TL2) gesetzt wird.

11. Verarbeitungseinrichtung zur Verarbeitung von Daten oder Signalen von Signal- oder Datenquellen 20, 21 mit unterschiedlichen Synchronisationsquellen, insbesonders ein Mess-, Prüf- oder Steuergerät für den Antriebstrang oder Komponenten davon, **dadurch gekennzeichnet, dass** eine Eingabeschnittstelle (2), über die die Daten oder Signale zuführbar sind, und eine Berechnungseinheit (12), in der für jede Synchronisationsquelle (SS1, SSn) eine Zeitebene (TL1, TLn) vorgesehen ist, in der Verarbeitungseinrichtung (1) vorgesehen sind, wobei in jeder Zeitebene (TL1, TL2) als Quelltakt der Takt der Synchronisationsquelle (SS1, SSn) verwendet wird und die dieser Synchronisationsquelle (SS1, SSn) zugeordneten Daten oder Signale (S1, Sn) in der zugehörigen Zeitebene (TL1, TL2) der Berechnungseinheit (12) synchron mit dem Quelltakt der Synchronisationsquelle (SS1, SSn) behandelbar sind.

12. Verarbeitungseinrichtung nach Anspruch 11, **dadurch gekennzeichnet, dass** in der Berechnungseinheit (12) zwei Signale oder Daten (S1, Sn) unterschiedlicher Zeitebenen (TL1, TLn) miteinander verknüpfbar sind, indem das Signal oder Datum (S1, Sn) einer ersten Zeitebene (TL1) in eine zweite Zeitebene (TLn) importiert wird und die Signale oder Daten in dieser zweiten Zeitebene (TL1, TLn) verknüpft werden.

13. Verarbeitungseinrichtung nach Anspruch 12, **dadurch gekennzeichnet, dass** in der Berechnungseinheit (12) eine Importeinrichtung vorgesehen ist, mit der das zu importierende Signal oder Datum (S1, Sn) im Quelltakt der Zeitebene (TLn), in die es importiert werden soll, abgetastet wird.

14. Verarbeitungseinrichtung nach Anspruch 12, **dadurch gekennzeichnet, dass** in der Berechnungseinheit (12) eine Importeinheit vorgesehen ist, mit der das zu importierende Signal oder Datum (S1, Sn) auf den Quelltakt der Zeitebene (TLn), in die es importiert werden soll, interpoliert wird.

15. Verarbeitungseinrichtung nach einem der Ansprüche 12 bis 14, **dadurch gekennzeichnet, dass** in der Berechnungseinheit (12) in einer Zeitebene (TL1, TLn) eine lokale Absolutzeit (TZ1, TZn) bildbar ist.

16. Verarbeitungseinrichtung nach Anspruch 15, **dadurch gekennzeichnet, dass** in der Berechnungseinheit (12) eine lokale Absolutzeit (TZ1, TZn) gemäß der Beziehung $TZ = t_0 + T_{CM} * CMT$ bildbar ist, wobei TZ die lokale Absolutzeit, $t_0$ eine Startzeit, $T_{CM}$ eine Zeitkonstante der Taktung und CMT die Anzahl der seit dem Startzeitpunkt vergangen Takte angibt.

17. Verarbeitungseinrichtung nach Anspruch 15 oder 16, **dadurch gekennzeichnet, dass** in der Berechnungseinheit (12) eine Importeinheit vorgesehen ist, mit der Daten oder Signale (S1, Sn) einer ersten Zeitebene (TL1) in eine zweite Zeitebene (TLn) importiert werden, indem die lokale Absolutzeit (TZ1) der ersten Zeitebene (TL1) in die lokale Absolutzeit (TZn) der zweiten Zeitebene (TZn) konvertiert wird.

18. Verarbeitungseinrichtung nach Anspruch 17, **dadurch gekennzeichnet, dass** die lokale Absolutzeit (TZ1) der ersten Zeitebene (TL1) in der Importeinheit in die lokale Absolutzeit (TZ2) der zweite Zeitebene (TL2) konvertiert wird, indem die Zeitkonstante ($T_{CM}$) der ersten Zeitebene (TL1) an die lokale Absolutzeit (TZ2) der zweiten Zeitebene (TL2) angepasst wird.

19. Verarbeitungseinrichtung nach Anspruch 18, **dadurch gekennzeichnet, dass** die Anpassung in der Importeinheit gemäß der Beziehung $T_{CM} = (TZ2 - t_0) /CMT$ durchführbar ist.

20. Verarbeitungseinrichtung nach einem der Ansprüche 17 bis 19, **dadurch gekennzeichnet, dass** die Startzeit ($t_0$) in der Berechnungseinheit (12) zu Beginn auf die aktuelle lokale Absolutzeit (TZ2) der zweiten Zeitebene (TL2) setzbar ist.

## Claims

1. A method for processing data or signals having different synchronization sources in a processing unit (1), in particular in a measuring, testing, or control device for the drive train or components thereof, **characterized in that** a time level (TL1, TLn) is introduced in the processing unit (1) for each synchronization source (SS1, SSn), with the clock of the synchronization source (SS1, SSn) being used as the source clock in each time level (TL1, TL2) and with the data or signals (S1, Sn) corresponding to this synchronization source (SS1, SSn) being processed in the appropriate time level (TL1, TL2) in synchronization with the source clock of the synchronization source (SS1, SSn).

2. The method according to Claim 1, **characterized in that** two signals or pieces of data (S1, Sn) having different time levels (TL1, TLn) are linked to one another **in that** the signal or piece of data (S1, Sn) of a first time level (TL1) is imported into a second time level (TLn) and the signals or data are linked in this second time level (TL1, TLn).

3. The method according to Claim 2, **characterized in that** the signal or piece of data (S1, Sn) to be imported is scanned in the source clock of the time level (TLn) into which it is to be imported.

4. The method according to Claim 2, **characterized in**

**that** the signal or piece of data (S1, Sn) to be imported is interpolated in the source clock of the time level (TLn) into which it is to be imported.

5. The method according to one of Claims 1 to 4, **characterized in that** a local absolute time (TZ1, TZn) is generated in a time level (TL1, TLn).

6. The method according to Claim 5, **characterized in that** a local absolute time (TZ1, TZn) is generated in accordance with the equation $TZ = t_0 + T_{CM} * CMT$, where TZ is the local absolute time, $t_0$ is a start time, $T_{CM}$ is a time constant of the clock, and CMT is the number of clocks that have passed since the start time point.

7. The method according to Claim 5 or 6, **characterized in that** data or signals (S1, Sn) of a first time level (TL1) are imported into a second time level (TLn) **in that** the local absolute time (TZ1) of the first time level (TL1) is converted into the local absolute time (TZn) of the second time level (TLn).

8. The method according to Claim 7, **characterized in that** the local absolute time (TZ1) of the first time level (TL1) is converted into the local absolute time (TZ2) of the second time level (TL2) **in that** the time constant ($T_{CM}$) of the first time level (TL1) is adapted to the local absolute time (TZ2) of the second time level (TL2).

9. The method according to Claim 8, **characterized in that** the adaptation is made using the equation $T_{CM} = (TZ2 - to)/CMT$.

10. The method according to one of Claims 1 to 9, **characterized in that** the start time ($t_0$) is set at the beginning at the current local absolute time (TZ2) of the second time level (TL2).

11. A processing unit for processing data or signals from signal or data sources 20, 21 having different synchronization sources, in particular a measuring, testing, or control device for the drive train or components thereof, **characterized in that** an input interface (2), by way of which the data or signals may be input, and a calculation unit (12), in which a time level (TL1, TLn) is provided for each synchronization source (SS1, SSn), are provided in the processing unit (1), with the clock of the synchronization source (SS1, SSn) being used as the source clock in each time level (TL1, TL2) and with the data or signals (S1, Sn) corresponding to this synchronization source (SS1, SSn) being able to be processed in the appropriate time level (TL1, TL2) in synchronization with the source clock of the synchronization source (SS1, SSn).

12. The processing unit according to Claim 11, **characterized in that** two signals or pieces of data (S1, Sn) of different time levels (TL1, TLn) may be linked to one another in the calculation unit (12) **in that** the signal or piece of data (S1, Sn) of a first time level (TL1) is imported into a second time level (TLn) and the signals or data are linked in this second time level (TL1, TLn).

13. The processing unit according to Claim 12, **characterized in that** an import unit is provided in the calculation unit (12) by means of which the signal or piece of data (S1, Sn) to be imported is scanned in the source clock of the time level (TLn) into which it is to be imported.

14. The processing unit according to Claim 12, **characterized in that** an import unit is provided in the calculation unit (12) by means of which the signal or piece of data (S1, Sn) to be imported is interpolated to the source clock of the time level (TLn) into which it is to be imported.

15. The processing unit according to one of Claims 12 to 14, **characterized in that** a local absolute time (TZ1, TZn) may be generated in the calculation unit (12) in a time level (TL1, TLn).

16. The processing unit according to Claim 15, **characterized in that** a local absolute time (TZ1, TZn) is generated in the calculation unit (12) according to the equation $TZ = t_0 + T_{CM} * CMT$, where TZ is the local absolute time, $t_0$ is a start time, $T_{CM}$ is a time constant of the clock, and CMT is the number of clocks that have passed since the start time point.

17. The processing unit according to Claim 15 or 16, **characterized in that** an importing unit is provided in the calculation unit (12) by means of which data or signals (S1, Sn) of a first time level (TL1) are imported into a second time level (TLn) **in that** the local absolute time (TZ1) of the first time level (TL1) is converted into the local absolute time (TZn) of the second time level (TLn).

18. The processing unit according to Claim 17, **characterized in that** the local absolute time (TZ1) of the first time level (TL1) is converted into the local absolute time (TZ2) of the second time level (TL2) **in that** the time constant ($T_{CM}$) of the first time level (TL1) is adapted to the local absolute time (TZ2) of the second time level (TL2).

19. The processing unit according to Claim 18, **characterized in that** the adaptation in the importing unit may be made in accordance with the equation $T_{CM} = (TZ2 - to)/CMT$.

**20.** The processing unit according to one of Claims 17 to 19, **characterized in that** the start time ($t_0$) may be set in the calculation unit (12) at the beginning to the current local absolute time (TZ2) of the second time level (TL2) .

**Revendications**

**1.** Procédé de traitement de données ou de signaux avec différentes sources de synchronisation dans un dispositif de traitement (1), en particulier dans un appareil de mesure, de contrôle ou de commande pour le groupe motopropulseur ou des composants de celui-ci, **caractérisé en ce que** dans le dispositif de traitement (1) pour chaque source de synchronisation (SS1, SSn) un plan temporel (TL1, TLn) est introduit, dans lequel dans chaque plan temporel (TL1, TL2) on utilise comme horloge source l'horloge de la source de synchronisation (SS1, SSn), et les données ou signaux (S1, Sn) attribués à cette source de synchronisation (SS1, SSn) sont traités dans le plan temporel (TL1, TL2) associé, en synchronisme avec l'horloge source de la source de synchronisation (SS1, SSn).

**2.** Procédé selon la revendication 1, **caractérisé en ce que** deux signaux ou données (S1, Sn) de différents plans temporels (TL1, TLn) sont associés ensemble **en ce que** le signal ou la donnée (S1, Sn) d'un premier plan temporel (TL1) est importé(e) dans un deuxième plan temporel (TLn) et les signaux ou données sont associés dans ce deuxième plan temporel (TL1, TLn).

**3.** Procédé selon la revendication 2, **caractérisé en ce que** le signal ou la donnée (S1, Sn) à importer est échantillonné(e) avec l'horloge source du plan temporel (TLn), dans lequel il ou elle doit être importé (e).

**4.** Procédé selon la revendication 2, **caractérisé en ce que** le signal ou la donnée (S1, Sn) à importer est interpolé(e) sur l'horloge source du plan temporel (TLn) dans lequel il ou elle doit être importé(e).

**5.** Procédé selon l'une quelconque des revendications 1 à 4, **caractérisé en ce que** dans un plan temporel (TL1, TLn), un temps absolu local (TZ1, TZn) est établi.

**6.** Procédé selon la revendication 5, **caractérisé en ce qu'**un temps absolu local (TZ1, TZn) est établi selon la relation $TZ = t_0 + T_{CM} * CMT$, où TZ est le temps absolu local, $t_0$ est un temps initial, $T_{CM}$ est une constante temporelle du cadencement, et CMT indique le nombre des cycles écoulés depuis l'instant initial.

**7.** Procédé selon la revendication 5 ou 6, **caractérisé en ce que** des données ou signaux (S1, Sn) d'un premier plan temporel (TL1) sont importés dans un deuxième plan temporel (TLn) **en ce que** le temps absolu local (TZ1) du premier plan temporel (TL1) est converti en temps absolu local (TZn) du deuxième plan temporel (TLn).

**8.** Procédé selon la revendication 7, **caractérisé en ce que** le temps absolu local (TZ1) du premier plan temporel (TL1) est converti en temps absolu local (TZ2) du deuxième plan temporel (TL2) **en ce que** la constante de temps ($T_{CM}$) du premier plan temporel (TL1) est adaptée au temps absolu local (TZ2) du deuxième plan temporel (TL2).

**9.** Procédé selon la revendication 8, **caractérisé en ce que** l'adaptation est effectuée selon la relation $T_{CM} = (TZ2 - to)/CMT$.

**10.** Procédé selon l'une quelconque des revendications 7 à 9, **caractérisé en ce que** le temps initial ($t_0$) est au début réglé sur le temps absolu local (TZ2) actuel du deuxième plan temporel (TL2).

**11.** Dispositif de traitement pour traiter des données ou signaux provenant de sources de signaux ou de données 20, 21 avec différentes sources de synchronisation, en particulier un appareil de mesure, de contrôle ou de commande pour den groupe motopropulseur ou des composants de celui-ci, **caractérisé en ce qu'**une interface d'entrée (2) par laquelle des données ou des signaux peuvent être amenés, et une unité de calcul (12), dans laquelle pour chaque source de synchronisation (SS1, SSn) un plan temporel (TL1, TLn) est prévu, sont prévues dans le dispositif de traitement (1), dans lequel dans chaque plan temporel (TL1, TL2) on utilise comme horloge source l'horloge de la source de synchronisation (SS1, SSn) et les données ou signaux (S1, Sn) attribués à cette source de synchronisation (SS1, SSn) peuvent être traités dans le plan temporel (TL1, TL2) associé de l'unité de calcul (12) en synchronisme avec l'horloge source de la source de synchronisation (SS1, SSn).

**12.** Dispositif de traitement selon la revendication 11, **caractérisé en ce que** dans l'unité de calcul (12), deux signaux ou données (S1, Sn) de différents plans temporels (TL1, TLn) peuvent être associés ensemble **en ce que** le signal ou la donnée (S1, Sn) d'un premier plan temporel (TL1) est importé(e) dans un deuxième plan temporel (TLn) et les signaux ou données sont associés dans ce deuxième plan temporel (TL1, TLn).

**13.** Dispositif de traitement selon la revendication 12, **caractérisé en ce que** dans l'unité de calcul (12), un dispositif d'importation est prévu par lequel le signal ou la donnée (S1, Sn) à importer est échantillonné(e) avec l'horloge source du plan temporel (TLn) dans lequel il ou elle doit être importé (e) .

14. Dispositif de traitement selon la revendication 12, **caractérisé en ce que** dans l'unité de calcul (12), une unité d'importation est prévue par laquelle le signal ou la donnée (S1, Sn) à importer est interpolé (e) sur l'horloge source du plan temporel (TLn) dans lequel il ou elle doit être importé (e) .

15. Dispositif de traitement selon l'une quelconque des revendications 12 à 14, **caractérisé en ce que** dans l'unité de calcul (12), dans un plan temporel (TL1, TLn), un temps absolu local (TZ1, TZn) peut être établi.

16. Dispositif de traitement selon la revendication 15, **caractérisé en ce que** dans l'unité de calcul (12), un temps absolu local (TZ1, TZn) peut être établi selon la relation $TZ = t_0 + T_{CM} * CMT$, où TZ est le temps absolu local, $t_0$ est un temps initial, T est une constante temporelle du cadencement, et CMT indique le nombre des cycles écoulés depuis l'instant initial.

17. Dispositif de traitement selon la revendication 15 ou 16, **caractérisé en ce que** dans l'unité de calcul (12), une unité d'importation est prévue, par laquelle des données ou signaux (S1, Sn) d'un premier plan temporel (TL1) sont importés dans un deuxième plan temporel (TLn) **en ce que** le temps absolu local (TZ1) du premier plan temporel (TL1) est converti en temps absolu local (TZn) du deuxième plan temporel (TLn).

18. Dispositif de traitement selon la revendication 17, **caractérisé en ce que** le temps absolu local (TZ1) du premier plan temporel (TL1) est converti dans l'unité d'importation en temps absolu local (TZ2) du deuxième plan temporel (TL2) **en ce que** la constante temporelle ($T_{CM}$) du premier plan temporel (TL1) est adaptée au temps absolu local (TZ2) du deuxième plan temporel (TL2).

19. Dispositif de traitement selon la revendication 18, **caractérisé en ce que** l'adaptation peut être effectuée dans l'unité d'importation selon la relation $T_{CM} = (TZ2 - t_0)/CMT$.

20. Dispositif de traitement selon l'une quelconque des revendications 17 à 19, **caractérisé en ce que** le temps initial ($t_0$) dans l'unité de calcul (12) peut être réglé sur le début du temps absolu local (TZ2) actuel du deuxième plan temporel (TL2).

EP 1 967 859 B1

Fig. 1

11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5896524 A